# EUROPEAN PATENT APPLICATION

(11) **EP 4 679 966 A1**
(43) Date of publication of application: **14.01.2026**
(21) Application number: 25181536.1
(22) Date of filing: 08.06.2025
(51) Int. Cl.: H10B 12/00

(54) **THREE-DIMENSIONAL SEMICONDUCTOR DEVICE**

(30) Priority: 12.07.2024 KR 20240092148
(71) Applicant: Samsung Electronics Co., Ltd., Suwon-si, Gyeonggi-do 16677 (KR)
(72) Inventor: PARK, Jungmin, 16677 Suwon-si (KR); KANG, Jungoo, 16677 Suwon-si (KR); KIM, Beom-Jong, 16677 Suwon-si (KR); JUNG, Hyungsuk, 16677 Suwon-si (KR)
(74) Representative: Marks & Clerk LLP

(57) **Abstract**

A three-dimensional semiconductor device may include a semiconductor pattern extending in a first direction parallel to a bottom surface of a substrate, a word line surrounding a portion of the semiconductor pattern and extending in a second direction, which is parallel to the bottom surface of the substrate and is orthogonal to the first direction, a bit line on a first side surface of the semiconductor pattern and extending in a third direction perpendicular to the bottom surface of the substrate, a capacitor on a second side surface of the semiconductor pattern opposite to the first side surface, and a metal silicide pattern between the capacitor and the second side surface of the semiconductor pattern. The capacitor may include a first electrode enclosing the metal silicide pattern, a second electrode on the first electrode, and a dielectric layer between the first electrode and the second electrode. The first electrode may include a metal oxide material.

## Description

### BACKGROUND OF THE INVENTION

The present disclosure relates to a three-dimensional semiconductor device, and in particular, to a three-dimensional semiconductor device with improved reliability and an increased integration density and a method of fabricating the same.

Due to their small-size, multifunctional, and/or low-cost characteristics, semiconductor devices are being esteemed as important elements in the electronics industry. The semiconductor devices may be classified into a semiconductor memory device for storing data, a semiconductor logic device for processing data, and a hybrid semiconductor device including both of memory and logic elements.

With the recent trend of high speed and low power consumption of electronic devices, semiconductor devices in the electronic devices may also be required to have high operating speeds and/or low operating voltages, and to satisfy this requirement, it may be necessary to increase an integration density of the semiconductor device. However, as the integration density of the semiconductor device increases, the semiconductor device may suffer from deteriorated electrical characteristics and low production yield. Accordingly, many studies are being conducted to improve the electrical characteristics and production yield of semiconductor devices.

### SUMMARY

An embodiment of the inventive concept provides a three-dimensional semiconductor device with an increased integration density.

An embodiment of the inventive concept provides a three-dimensional semiconductor device that can be fabricated by a simplified fabrication process.

According to an embodiment of the inventive concept, a three-dimensional semiconductor device may include a semiconductor pattern extending in a first direction parallel to a bottom surface of a substrate, a word line surrounding a portion of the semiconductor pattern and extending in a second direction, which is parallel to the bottom surface of the substrate and is orthogonal to the first direction, a bit line on a first side surface of the semiconductor pattern and extending in a third direction perpendicular to the bottom surface of the substrate, a capacitor on a second side surface of the semiconductor pattern opposite to the first side surface, and a metal silicide pattern between the capacitor and the second side surface of the semiconductor pattern. The capacitor may include a first electrode enclosing the metal silicide pattern, a second electrode on the first electrode, and a dielectric layer between the first electrode and the second electrode. The first electrode may include a metal oxide material.

According to an embodiment of the inventive concept, a three-dimensional semiconductor device may include a semiconductor pattern extending in a first direction parallel to a bottom surface of a substrate, a word line surrounding a portion of the semiconductor pattern and extending in a second direction, which is parallel to the bottom surface of the substrate and is orthogonal to the first direction, a bit line on a first side surface of the semiconductor pattern and extending in a third direction perpendicular to the bottom surface of the substrate, a metal silicide pattern on a second side surface of the semiconductor pattern opposite to the first side surface, and a first electrode enclosing the metal silicide pattern. The metal silicide pattern may include a first metal element and silicon, and the first electrode may include the first metal element and oxygen.

According to an embodiment of the inventive concept, a three-dimensional semiconductor device may include a first stack and a second stack, which are on a substrate and are adjacent to each other in a first direction parallel to a bottom surface of the substrate, and a data storage pattern between the first stack and the second stack. The first stack may include a first semiconductor pattern spaced apart from the substrate and extending in the first direction, a first word line surrounding a portion of the first semiconductor pattern and extending in a second direction, which is parallel to the bottom surface of the substrate and is orthogonal to the first direction, a first bit line provided on a first side surface of the first semiconductor pattern and extending in a third direction perpendicular to the bottom surface of the substrate, and a metal silicide pattern on a second side surface of the first semiconductor pattern. The data storage pattern may include a first electrode enclosing the metal silicide pattern, a second electrode on the first electrode, a dielectric layer between the first electrode and the second electrode, and a plate electrode in contact with the second electrode. The first electrode may include a metal oxide material.

At least some of the above and other features of the invention are set out in the claims.

### BRIEF DESCRIPTION OF THE DRAWINGS

FIG. 1 is a block diagram illustrating a three-dimensional semiconductor device according to an embodiment of the inventive concept.
FIG. 2 is a perspective view illustrating semiconductor patterns, word lines, bit lines, and a data storage pattern in a three-dimensional semiconductor device according to an embodiment of the inventive concept.
FIG. 3 is a plan view illustrating a three-dimensional semiconductor device according to an embodiment of the inventive concept.
FIG. 4A is a sectional view corresponding to a line A-A' of FIG. 3.
FIG. 4B is a sectional view corresponding to a line B-B' of FIG. 3.
FIG. 5 is an enlarged view corresponding to a portion 'P1' of FIG. 4A.
FIGS. 6, 7, 8A, 8B, 9, 10A, 10B, 11 - 13, 14A, 14B, 15, 16A, 16B, and 17 to 22 are diagrams illustrating a method of fabricating a three-dimensional semiconductor device, according to an embodiment of the inventive concept.

### DETAILED DESCRIPTION

Example embodiments of the inventive concepts will now be described more fully with reference to the accompanying drawings, in which example embodiments are shown. The same reference numerals are given to the same elements in the drawings, and repeated descriptions thereof are omitted. As used herein, the term "and/or" includes any and all combinations of one or more of the associated listed items. It will be understood that when an element is referred to as being "on," "attached" to, "connected" to, "coupled" with, "contacting," etc., another element, it can be directly on, attached to, connected to, coupled with or contacting the other element or intervening elements may also be present. In contrast, when an element is referred to as being, for example, "directly on," "directly attached" to, "directly connected" to, "directly coupled" with or "directly contacting" another element, there are no intervening elements present. It will be understood that, although the terms "first," "second," etc. may be used herein to describe various elements or components, these elements or components should not be limited by these terms. These terms are only used to distinguish one element or component from another element or component. It is noted that aspects described with respect to one embodiment may be incorporated in different embodiments although not specifically described relative thereto. That is, all embodiments and/or features of any embodiments can be combined in any way and/or combination.

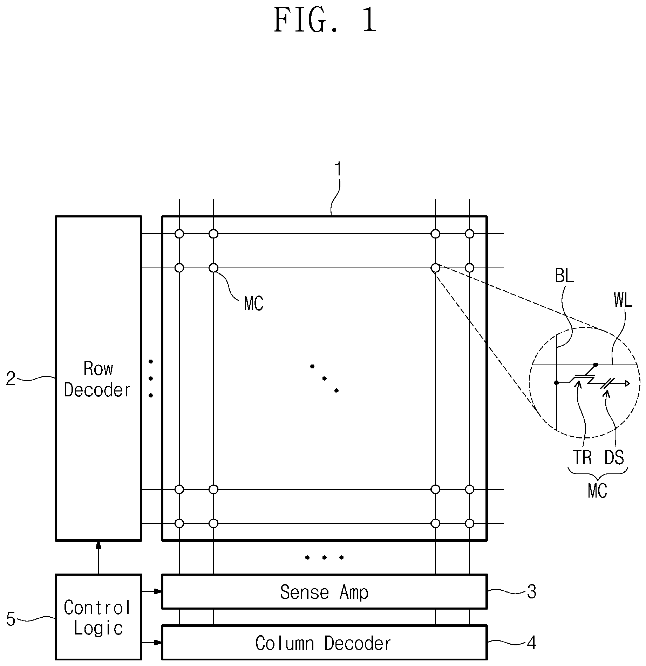

FIG. 1 is a block diagram illustrating a three-dimensional semiconductor device according to an embodiment of the inventive concept.

Referring to FIG. 1, a three-dimensional semiconductor device may include a memory cell array 1, a row decoder 2, a sensing amplifier 3, a column decoder 4, and a control logic 5.

The memory cell array 1 may include a plurality of memory cells MC, which are three-dimensionally arranged. Each of the memory cells MC may be disposed between, and connected to, a word line WL and a bit line BL, which are disposed to cross each other.

Each of the memory cells MC may include a switching device TR and a data storage device DS, which are electrically connected to each other in series. The switching device TR may be a field effect transistor FET, and the data storage device DS may be realized by a capacitor or a variable resistor. In an embodiment, the switching device TR may include a transistor including a gate electrode, which is connected to the word line WL, and drain/source terminals, which are respectively connected to the bit line BL and the data storage device DS.

The row decoder 2 may be configured to decode address information, which is an external input to the row decoder 2, and to select one of the word lines WL of the memory cell array 1, based on the decoded address information. The address information decoded by the row decoder 2 may be provided to a row driver (not shown), and in this case, the row driver may provide respective voltages to the selected one of the word lines WL and the unselected ones of the word lines WL, in response to the control signal(s) of a control circuit.

The sense amplifier 3 may be configured to sense, amplify, and output a difference in voltage between one of the bit lines BL, which is selected based on address information decoded by the column decoder 4, and a reference bit line.

The column decoder 4 may provide a data transmission path between the sensing amplifier 3 and an external device (e.g., a memory controller). The column decoder 4 may be configured to decode address information, which is input from the outside, and to select one of the bit lines BL, based on the decoded address information.

The control logic 5 may be configured to generate control signals, which are used to control data-writing or data-reading operations on the memory cell array 1.

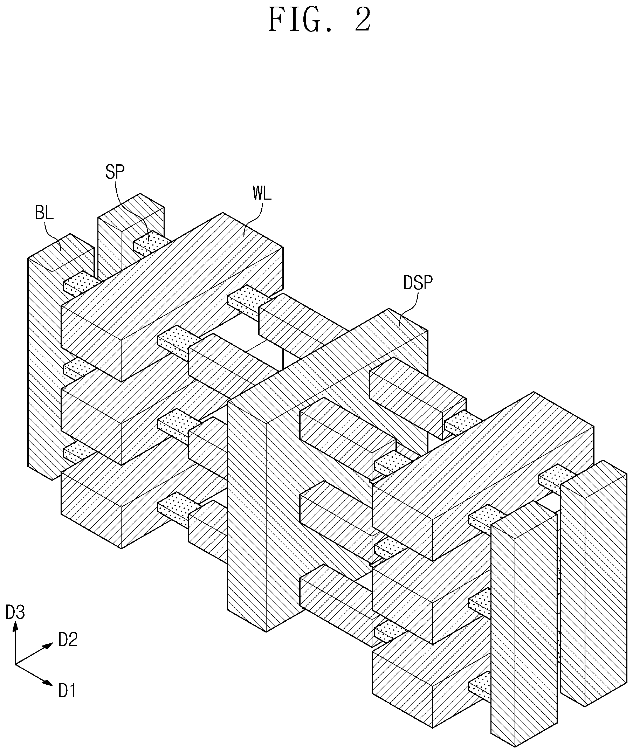

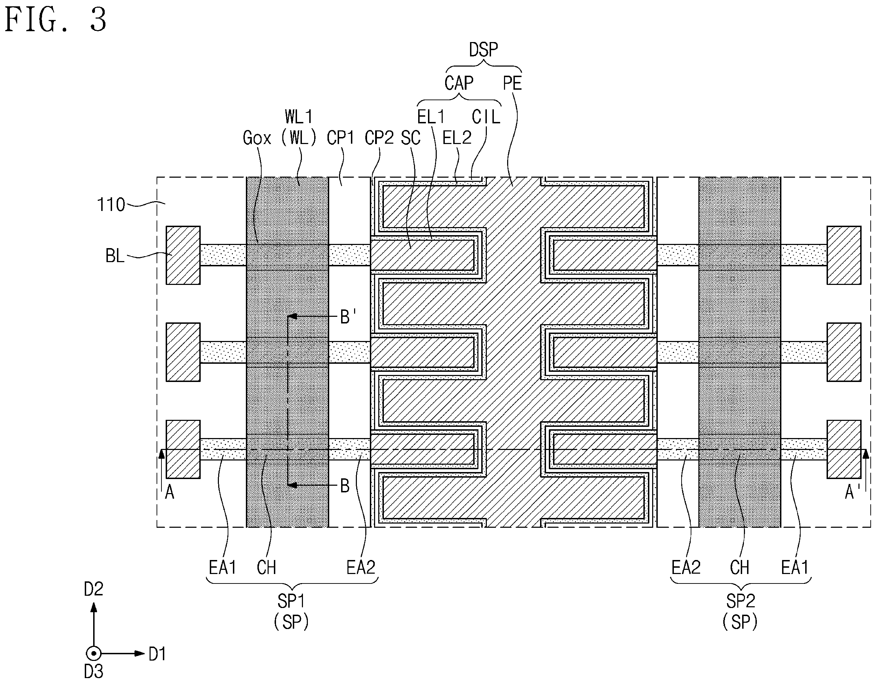

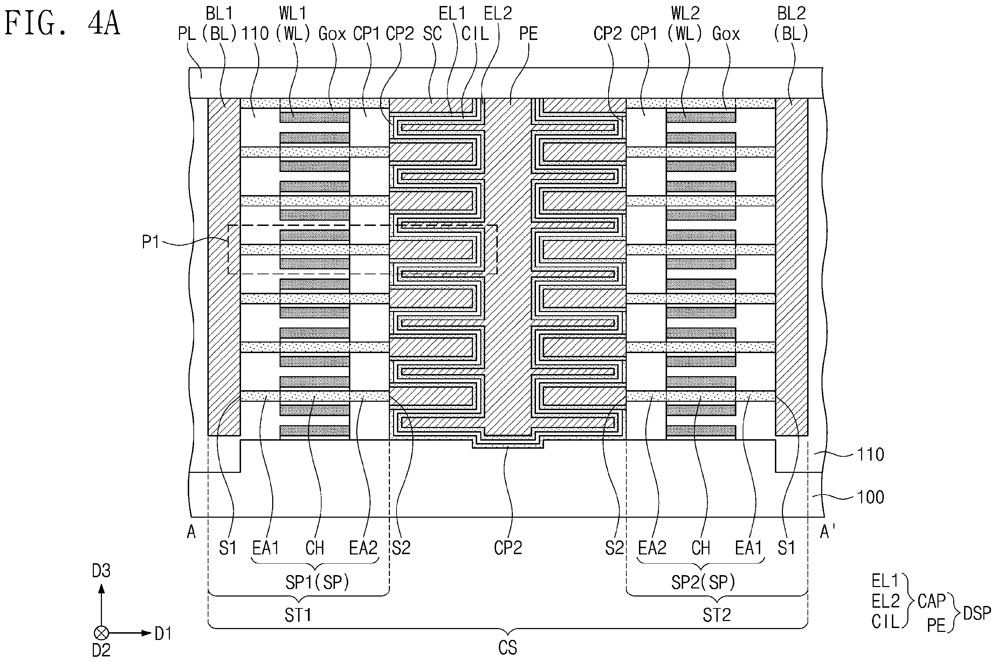

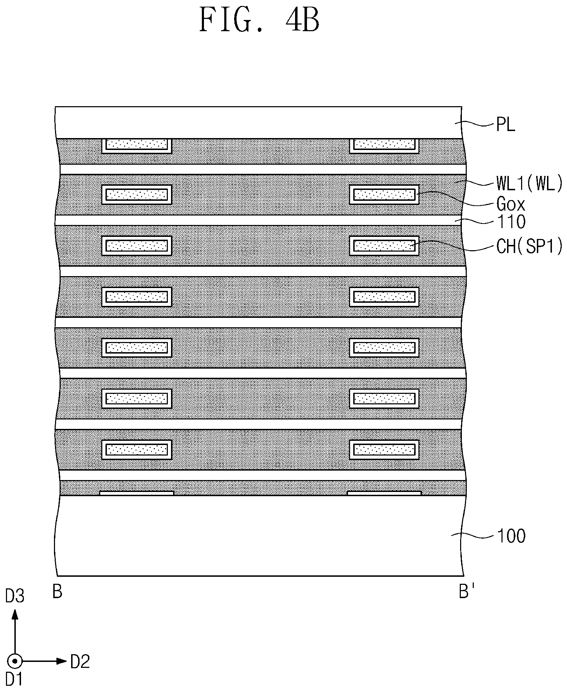

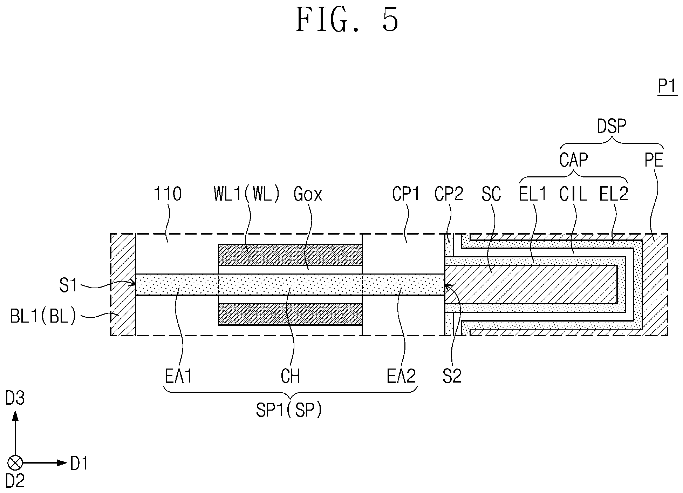

FIG. 2 is a perspective view illustrating semiconductor patterns, word lines, bit lines, and a data storage pattern in a three-dimensional semiconductor device according to an embodiment of the inventive concept. FIG. 3 is a plan view illustrating a three-dimensional semiconductor device according to an embodiment of the inventive concept. FIG. 4A is a sectional view corresponding to a line A-A' of FIG. 3. FIG. 4B is a sectional view corresponding to a line B-B' of FIG. 3. FIG. 5 is an enlarged view corresponding to a portion 'P1' of FIG. 4A.

Referring to FIGS. 2 to 4A and 4B, a three-dimensional semiconductor device may include a substrate 100. In an embodiment, the substrate 100 may be a silicon substrate, a germanium substrate, a silicon-germanium substrate, an insulating substrate, a silicon-on-insulator (SOI) substrate, and/or a germanium-on-insulator (GOI) substrate. The substrate 100 may be a plate-shaped structure that extends parallel to a plane defined by a first direction D1 and a second direction D2. In the present specification, the first direction D1 and the second direction D2 may be parallel to a bottom surface of the substrate 100 as shown in FIG. 4A and may not be parallel to each other. A third direction D3 may be perpendicular to the bottom surface of the substrate 100. In an embodiment, the first to third directions D1, D2, and D3 may be orthogonal to each other.

A cell array structure CS may be provided on the substrate 100. The cell array structure CS may include a first stack ST1 and a second stack ST2, which are adjacent to each other in the first direction D1, and a data storage pattern DSP therebetween. In an embodiment, the cell array structure CS may further include a plurality of stacks ST1 and ST2 and data storage patterns DSP, which are arranged in the first direction D1.

Each of the first and second stacks ST1 and ST2 may include semiconductor patterns SP, word lines WL, bit lines BL, metal silicide patterns SC, first capping patterns CP1, second capping patterns CP2, and a gapfill insulating pattern 110. In an embodiment, the first and second stacks ST1 and ST2 may be provided to have a mirror symmetry with respect to the data storage pattern DSP.

The semiconductor pattern SP may extend in the first direction D1, on the substrate 100. The semiconductor pattern SP may be spaced apart from the substrate 100. That is, the semiconductor pattern SP may be arranged in a floating configuration with respect to the substrate 100. In an embodiment, a plurality of semiconductor patterns SP may be provided. The semiconductor patterns SP may be spaced apart from each other in the second direction D2 and the third direction D3. When viewed in a plan view, the semiconductor patterns SP, which are spaced apart from each other in the third direction D3, may at least partially overlap each other.

The semiconductor pattern SP may include a first edge portion EA1 and a second edge portion EA2, which are spaced apart from each other in the first direction D1, and a channel region CH therebetween. The channel region CH of the semiconductor pattern SP may be enclosed by the word line WL as shown in FIG. 4B. The first edge portion EA1 of the semiconductor pattern SP may be adjacent to the bit line BL. The first edge portion EA1 may be electrically connected to the bit line BL. The second edge portion EA2 may be adjacent to a capacitor CAP, which will be described below. The second edge portion EA2 may be electrically connected to the data storage pattern DSP.

The semiconductor pattern SP may have a first side surface S1 and a second side surface S2, which are opposite to each other in the first direction D1. The first side surface S1 may mean a side surface of the first edge portion EA1, and the second side surface S2 may mean a side surface of the second edge portion EA2. In other words, the first side surface S1 of the semiconductor pattern SP may be in contact with the bit line BL, and the second side surface S2 may be in contact with the metal silicide pattern SC.

The semiconductor pattern SP may be formed of or include one or more single-crystalline semiconductor materials, polycrystalline semiconductor materials, oxide semiconductor materials, and/or two-dimensional materials. In an embodiment, the single-crystalline semiconductor material may be single-crystalline silicon. In an embodiment, the polycrystalline semiconductor materials may be poly silicon. In an embodiment, the oxide semiconductor materials may be indium gallium zinc oxide (IGZO). In an embodiment, the two-dimensional material may be MoS₂, WS₂, MoSe₂, or WSe₂.

In an embodiment, each of the first and second edge portions EA1 and EA2 of the semiconductor pattern SP may include an impurity region that is doped with impurities (e.g., n- or p-type impurities). The impurity region may be used as a source/drain region of a transistor.

The semiconductor pattern SP may include a first semiconductor pattern SP1 provided in the first stack ST1 and a second semiconductor pattern SP2 provided in the second stack ST2. The first semiconductor pattern SP1 may be spaced apart from the second semiconductor pattern SP2 in the first direction D1. The first edge portion EA1, the channel region CH, and the second edge portion EA2 of the first semiconductor pattern SP1 and the first edge portion EA1, the channel region CH, and the second edge portion EA2 of the second semiconductor pattern SP2 may be sequentially disposed in the first direction D1.

The word line WL may be provided to enclose a portion (e.g., the channel region CH) of the semiconductor pattern SP and may extend in the second direction D2. In an embodiment, the word line WL may have a structure (i.e., a gate-all-around structure) that fully surrounds the channel region CH of the semiconductor pattern SP in a cross-sectional view. Each word line WL may be provided to at least partially enclose the channel region CH of each of the semiconductor patterns SP, which are spaced apart from each other in the second direction D2. In an embodiment, a plurality of word lines WL may be provided. Each of the word lines WL may be provided to at least partially enclose the channel region CH of a corresponding one of the semiconductor patterns SP, which are spaced apart from each other in the third direction D3, and may extend in the second direction D2. The word lines WL may be spaced apart from each other in the third direction D3.

The word line WL may include a first word line WL1, which is provided in the first stack ST1 to at least partially enclose the channel region CH of the first semiconductor pattern SP1, and a second word line WL2, which is provided in the second stack ST2 to at least partially enclose the channel region CH of the second semiconductor pattern SP2. The first word line WL1 and the second word line WL2 may be spaced apart from each other in the first direction D1.

The word line WL may be formed of or include one or more doped polysilicon, metallic materials (e.g., Al, Cu, Ti, Ta, Ru, W, Mo, Pt, Ni, and Co), conductive metal nitride materials (e.g., TiN, TaN, WN, NbN, TiAlN, TiSiN, TaSiN, and RuTiN), conductive metal silicide materials, and/or conductive metal oxide materials (e.g., PtO, RuO₂, IrO₂, SrRuO₃ (SRO), (Ba,Sr)RuO₃ (BSRO), CaRuO₃ (CRO), and LSCo), but embodiments of the inventive concept are not limited to these examples. The word line WL may be a single- or multi-layered structure formed of the afore-described materials. In an embodiment, the word line WL may include one or more two-dimensional semiconductor materials (e.g., graphene, carbon nanotube, or combinations thereof).

A gate insulating layer Gox may be interposed between the word line WL and the semiconductor pattern SP. The gate insulating layer Gox may at least partially enclose the semiconductor pattern SP. The word line WL on the gate insulating layer Gox may be provided to at least partially enclose the channel region CH of the semiconductor pattern SP. In an embodiment, a plurality of gate insulating layers Gox may be provided. Each of the gate insulating layers Gox may at least partially enclose a corresponding one of the semiconductor patterns SP.

The gate insulating layer Gox may include one or more materials, such as silicon oxide, silicon oxynitride, and/or high-k dielectric materials. The high-k dielectric material may include metal oxide materials and/or metal oxynitride materials. For example, the high-k dielectric material, which is used as the gate insulating layer Gox, may include one or more of HfO₂, HfSiO, HfSiON, HfraO, HfTiO, HfZrO, ZrO₂, and/or Al₂O₃, but embodiments of the inventive concept are not limited to this example. The high-k dielectric material may be defined as a material having a higher dielectric constant than silicon oxide.

The bit line BL may be provided on the first side surface S1 of the semiconductor pattern SP. The bit line BL on the first side surface S1 of the semiconductor pattern SP may extend in the third direction D3. Thus, each bit line BL may be in contact with the first side surfaces S1 of the semiconductor patterns SP, which are spaced apart from each other in the third direction D3, and may be electrically connected to the semiconductor patterns SP. In an embodiment, a plurality of bit lines BL may be provided. The bit lines BL may be spaced apart from each other in the second direction D2.

The bit line BL may be formed of or include at least one of, for example, doped polysilicon, metallic materials (e.g., Al, Cu, Ti, Ta, Ru, W, Mo, Pt, Ni, and Co), conductive metal nitride materials (e.g., TiN, TaN, WN, NbN, TiAlN, TiSiN, TaSiN, and RuTiN), conductive metal silicide materials, and/or conductive metal oxide materials (e.g., PtO, RuO₂, IrO₂, SrRuO₃ (SRO), (Ba,Sr)RuO₃ (BSRO), CaRuO₃ (CRO), and LSCo), but embodiments of the inventive concept are not limited to this example. The bit line BL may be a single- or multi-layered structure formed of the afore-described materials. In an embodiment, the bit line BL may be formed of or include one or more two-dimensional semiconductor materials (e.g., graphene, carbon nanotube, or combinations thereof).

The bit line BL may include a first bit line BL1, which is provided in the first stack ST1 and on the first side surface S1 of the first semiconductor pattern SP1. In addition, the bit line BL may include a second bit line BL2, which is provided in the second stack ST2 and on the first side surface S1 of the second semiconductor pattern SP2.

The metal silicide pattern SC may be provided on the second side surface S2 of the semiconductor pattern SP. The metal silicide pattern SC may extend from the second edge portion EA2 in the first direction D1 (e.g., outward from the semiconductor pattern SP). In an embodiment, a plurality of metal silicide patterns SC may be provided. The metal silicide patterns SC may be respectively disposed on side surfaces of the second edge portions EA2 of the semiconductor patterns SP. The metal silicide patterns SC may be spaced apart from each other in the second direction D2 and the third direction D3. The metal silicide patterns SC, which are spaced apart from each other in the third direction D3, may at least partially overlap each other, when viewed in a plan view.

In more detail, referring to FIGS. 3, 4A, and 5, the metal silicide pattern SC may be in contact with the side surface of the second edge portion EA2 or may be in contact with the second side surface S2 of the semiconductor pattern SP. A thickness of the metal silicide pattern SC in the third direction D3 may be greater than a thickness of the second edge portion EA2 in the third direction D3. Furthermore, the thickness according to the third direction D3 of the metal silicide pattern SC may be greater than a thickness of the semiconductor pattern SP in the third direction D3. The metal silicide pattern SC may be in contact with a side surface of the first capping pattern CP1.

The metal silicide pattern SC may include a first metal element and silicon. In an embodiment, the first metal element may include titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), and/or zirconium (Zr). In an embodiment, single- or poly-crystalline silicon may be disposed in the metal silicide pattern SC, although not shown.

Furthermore, the gapfill insulating pattern 110 may be provided on the substrate 100. The gapfill insulating pattern 110 may at least partially cover a side surface of the cell array structure CS. The gapfill insulating pattern 110 may be interposed between the bit line BL and the word line WL, between the semiconductor patterns SP separated from each other in the third direction D3, between the first edge portions EA1 separated from each other in the second direction D2, and between the word lines WL separated from each other in the third direction D3. The gapfill insulating pattern 110 may at least partially cover the first edge portion EA1. The gapfill insulating pattern 110 may include a single or composite layer including an insulating material.

The first capping patterns CP1 may be provided in each of the stacks ST1 and ST2. The first capping patterns CP1 may be interposed between the word lines WL and the data storage pattern DSP. The first capping patterns CP1 may be interposed between the second edge portions EA2 of the semiconductor patterns SP, which are spaced apart from each other in the third direction D3. The first capping pattern CP1 may be provided to at least partially surround the second edge portion EA2. The first capping pattern CP1 may be interposed between the second edge portions EA2 of the semiconductor patterns SP, which are spaced apart from each other in the second direction D2. The first capping pattern CP1 may conformally at least partially cover a side surface of the gapfill insulating pattern 110, a side surface of the word line WL, and a side surface of the gate insulating layer Gox.

A second capping pattern CP2 may be disposed on a side surface of the first capping pattern CP1 and between the substrate 100 and a dielectric layer CIL (e.g., see FIG. 5). The first capping pattern CP1 may include a single or composite layer including an insulating material.

The second capping pattern CP2 may at least partially cover a portion of the side surface of the first capping pattern CP1. The second capping pattern CP2 may be disposed between the metal silicide patterns SC, which are spaced apart from each other in the second and third directions D2 and D3. The second capping pattern CP2 may be in contact with a first electrode EL1, which will be described below. The second capping pattern CP2 may include an oxygen-containing insulating material.

The data storage pattern DSP may be interposed between the first stack ST1 and the second stack ST2. The data storage pattern DSP may be interposed between the first semiconductor pattern SP1 and the second semiconductor pattern SP2. The data storage pattern DSP may be in contact with the metal silicide pattern SC on the second side surface S2 of the first semiconductor pattern SP1 and may be electrically connected to the first semiconductor pattern SP1. The data storage pattern DSP may be in contact with the metal silicide pattern SC on the second side surface S2 of the second semiconductor pattern SP2 and may be electrically connected to the second semiconductor pattern SP2. In an embodiment, the three-dimensional semiconductor device may be a dynamic random access memory (DRAM) device.

The data storage pattern DSP may include the capacitor CAP, which is provided on the second side surface S2 of the semiconductor pattern SP, and a plate electrode PE, which is in contact with the capacitor CAP. The capacitor CAP may include a first electrode EL1 at least partially enclosing the metal silicide pattern SC, a second electrode EL2 on the first electrode EL1, and the dielectric layer CIL between the first electrode EL1 and the second electrode EL2.

The first electrode EL1 may at least partially enclose the metal silicide pattern SC. In detail, the first electrode EL1 may cover a top surface, a bottom surface, and a side surface of the metal silicide pattern SC. For example, the first electrode EL1 may conformally at least partially cover an end portion of the metal silicide pattern SC and may not cover an opposite end portion of the metal silicide pattern SC. The first electrode EL1 may be in contact with the first and second capping patterns CP1 and CP2. The first electrode EL1 may be spaced apart from the semiconductor pattern (in particular, the second edge portion EA2). In an embodiment, a thickness of the first electrode EL1 may range from 0 A to 50 Å.

The first electrode EL1 may include a metal oxide material containing the first metal element. In an embodiment, the first electrode EL1 may include the first metal element and/or oxygen, but not nitrogen. The first metal element may mean the first metal element in the metal silicide pattern SC described above. In other words, the first electrode EL1 and the metal silicide pattern SC may include the same metal element (i.e., the first metal element), and this may be as a result of a fabrication process according to an embodiment of the inventive concept. Similarly, the first metal element may be titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), and/or zirconium (Zr).

The first electrode EL1 may further include a second metal element different from the first metal element. In an embodiment, the second metal element may be titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), and/or zirconium (Zr). In an embodiment, a work function of the second metal element may have a value of 4.5 eV or higher. In detail, the work function of the second metal element may range from 4.5 eV to 50 eV. In the case where the work function of the second metal element in the first electrode EL1 is greater than a specific value, it may be possible to reduce a leakage current in the capacitor CAP and to improve the electric stability of the capacitor CAP.

The second electrode EL2 may be disposed on a side surface of the first electrode EL1. The second electrode EL2 may be spaced apart from the first electrode EL1 with the dielectric layer CIL interposed therebetween. In an embodiment, the second electrode EL2 may be formed of or include one or more materials, such as, for example, metal nitride materials (e.g., nitrides of Ti, Mo, W, Cu, Al, Ta, Ru, Ir, Co, Pt, Au, and Ag, titanium silicon nitride (e.g., TiSiN), titanium aluminum nitride (e.g., TiAlN), and/or tantalum aluminum nitride (e.g., TaAlN)).

The dielectric layer CIL may be disposed between the first electrode EL1 and the second electrode EL2. The dielectric layer CIL may at least partially cover the first electrode EL1. The dielectric layer CIL may be formed of or include one or more ferroelectric, antiferroelectric, and/or paraelectric materials. In an embodiment, the dielectric layer CIL may include one or more materials, such as, for example, metal oxide materials (e.g., HfO2, ZrO2, Al₂O₃, La₂O₃, Ta₂O₃, and TiO₂) and/or perovskite dielectric materials (e.g., SrTiO₃ (STO), (Ba,Sr)TiO₃ (BST), BaTiO₃, PZT, and PLZT).

The plate electrode PE may be formed to at least partially fill a space in the second electrode EL2. The plate electrode PE may be in contact with the second electrode EL2. The plate electrode PE may include a vertical portion extending in the third direction D3 and horizontal portions protruding from the vertical portion in the first direction D1 or an opposite direction of the first direction D1. The horizontal portion of the plate electrode PE may be interposed between the metal silicide patterns SC, which are adjacent to each other in the third direction D3. In an embodiment, the plate electrode PE may include doped silicon (Si) and/or doped silicon-germanium (SiGe).

Referring back to FIGS. 4A and 4B, a protection layer PL may be provided on the cell array structure CS. The protection layer PL may at least partially cover the top surfaces of the first stack ST1, the second stack ST2, and the data storage pattern DSP. The protection layer PL may include a single or composite layer including an insulating material. The protection layer PL may include a plurality of upper interconnection lines (not shown) provided therein. Some of the upper interconnection lines may be electrically connected to the bit line BL and the data storage pattern DSP, respectively. In addition, although not shown, word line pads (not shown) may be provided on the side surface of the cell array structure CS and may be electrically connected to the word lines WL.

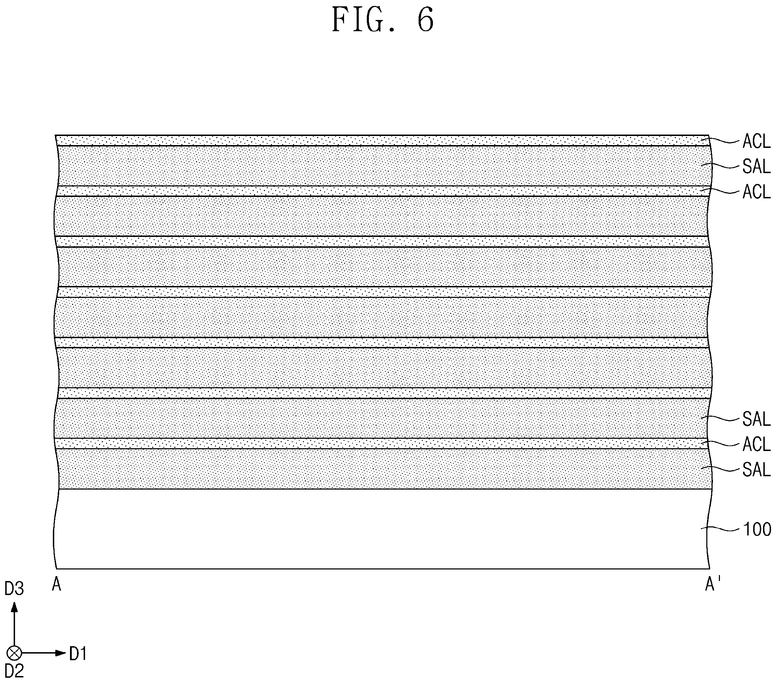

Hereinafter, a method of fabricating a three-dimensional semiconductor device, according to an embodiment of the inventive concept, will be described in more detail with reference to FIGS. 6, 7, 8A, 8B, 9, 10A, 10B, 11 - 13, 14A, 14B, 15, 16A, 16B, and 17 to 22. In the following description, a previously-described element may be identified by the same reference number without repeating an overlapping description thereof, for concise description.

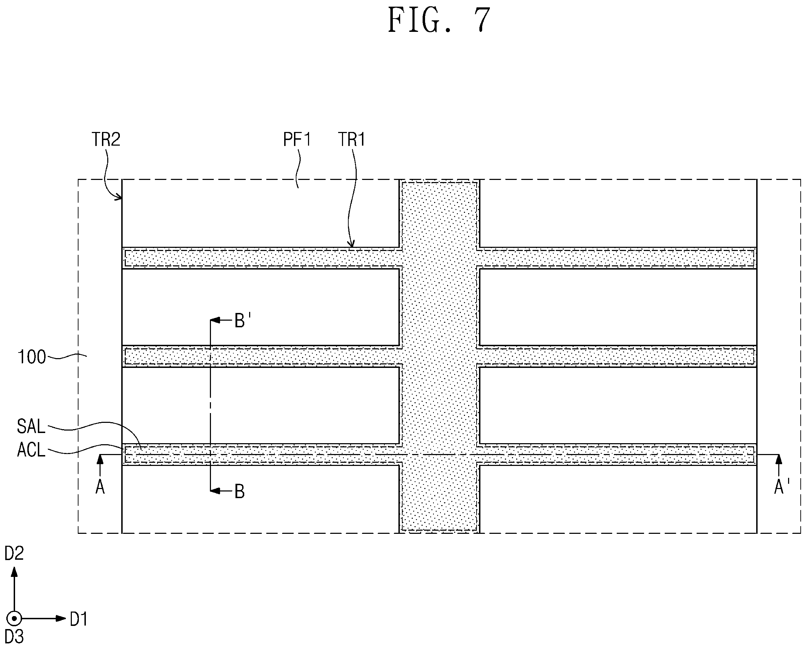

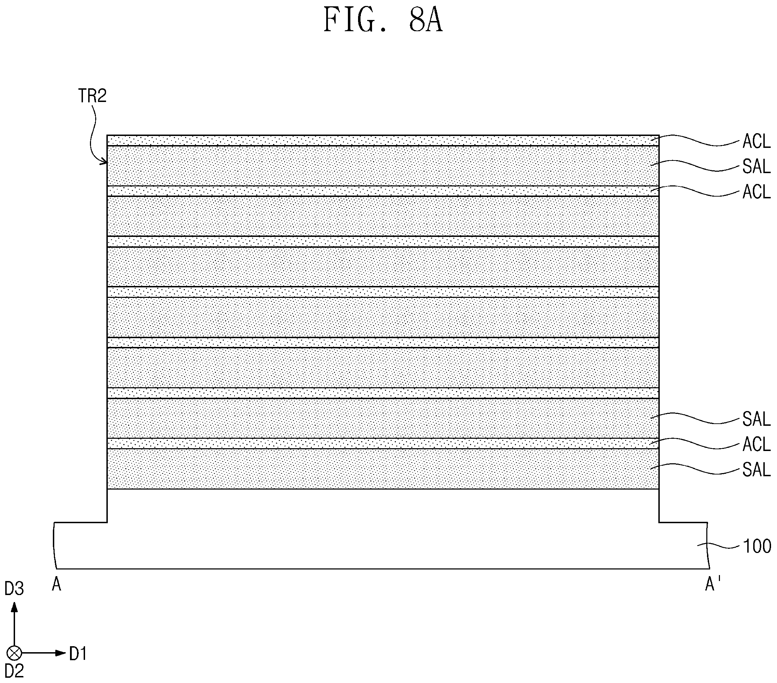

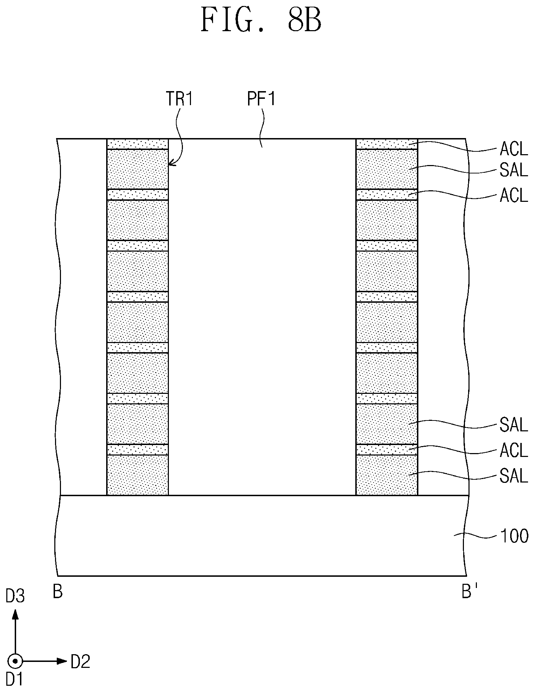

FIGS. 6, 7, 8A, 8B, 9, 10A, 10B, 11 - 13, 14A, 14B, 15, 16A, 16B, and 17 to 22 are diagrams illustrating a method of fabricating a three-dimensional semiconductor device, according to an embodiment of the inventive concept. In detail, FIG. 6 is a sectional view corresponding to the line A-A' of FIG. 3. FIGS. 7, 9, 11, 13, 15, 17, 19, and 21 are plan views illustrating a method of fabricating a three-dimensional semiconductor device, according to an embodiment of the inventive concept. FIGS. 8A, 10A, 12, 14A, 16A, 18, 20, and 22 are sectional views taken along lines A-A' of FIGS. 7, 9, 11, 13, 15, 17, 19, and 21, respectively. FIGS. 8B, 10B, 14B, and 16B are sectional views taken along lines B-B' of FIGS. 7, 9, 13, and 15, respectively. For concise description, a previously described element may be identified by the same reference number without repeating an overlapping description thereof.

Referring to FIG. 6, the substrate 100 may be provided. Sacrificial layers SAL and active layers ACL may be alternately stacked on the substrate 100. Each of the sacrificial and active layers SAL and ACL may be formed of or include a semiconductor material. The sacrificial layers SAL may include a material having an etch selectivity with respect to the active layers ACL. Thus, even when the sacrificial layers SAL are removed, the active layers ACL may be less removed in a subsequent process of removing the sacrificial layers SAL. In an embodiment, the active and sacrificial layers ACL and SAL may be formed of or include at least one of silicon (Si), germanium (Ge), or silicon germanium (SiGe), but the material of the sacrificial layers SAL may be different from that of the active layers ACL. In an embodiment, the active layers ACL may include silicon (Si), and the sacrificial layers SAL may include silicon-germanium (SiGe). A thickness of the sacrificial layers SAL may be greater than a thickness of the active layers ACL.

Referring to FIGS. 7 to 8A and 8B, first trenches TR1 may be formed on the substrate 100 by etching the sacrificial and active layers SAL and ACL. The first trenches TR1 may extend in the first direction D1 and may be spaced apart from each other in the first and second directions D1 and D2. A portion of a top surface of the substrate 100 may be exposed to the outside through the first trenches TR1. As a result of the removal process, the sacrificial and active layers SAL and ACL may be formed to include branch portions, which extend in the first direction D1 between the first trenches TR1 separated from each other in the second direction D2, and stem portions, which extend in the second direction D2 between the first trenches TR1 separated from each other in the first direction D1.

First preliminary filling patterns PF1 may be formed to at least partially cover the exposed portion of the top surface of the substrate 100 and to at least partially fill the first trenches TR1. The first preliminary filling patterns PF1 may be formed to be spaced apart from each other in the first and second directions D1 and D2. In an embodiment, the first preliminary filling pattern PF1 may include an insulating material.

Second trenches TR2 may be formed on the substrate 100 by removing some of the stem portions of the sacrificial and active layers SAL and ACL extending in the second direction D2. The second trenches TR2 may be spaced apart from each other in the first direction D1 and may extend in the second direction D2. Opposite side surfaces of the sacrificial and active layers SAL and ACL may be exposed to the outside through the second trenches TR2. In an embodiment, when the second trenches TR2 are formed, an upper portion of the substrate 100 may be partially removed. A portion of the top surface of the substrate 100 may be exposed to the outside by the second trenches TR2.

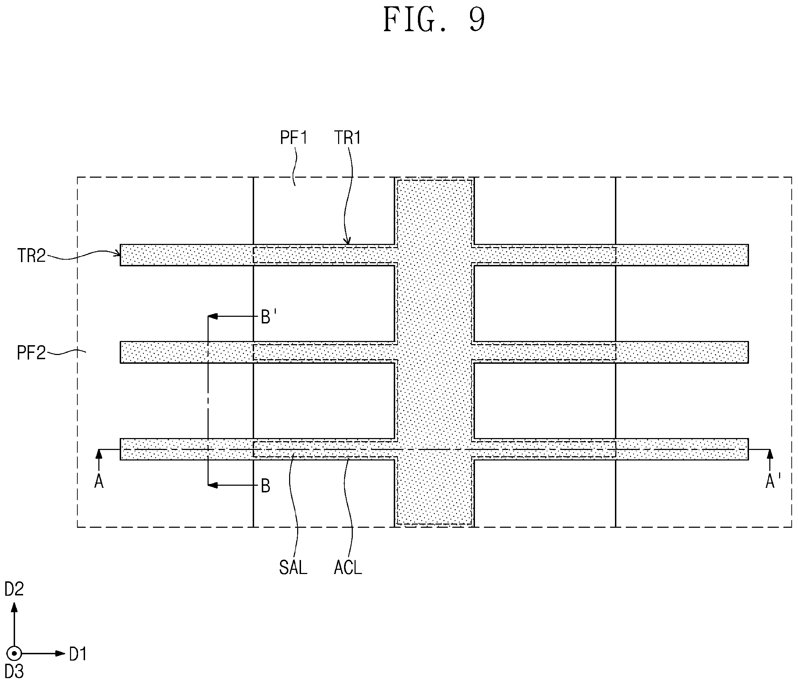

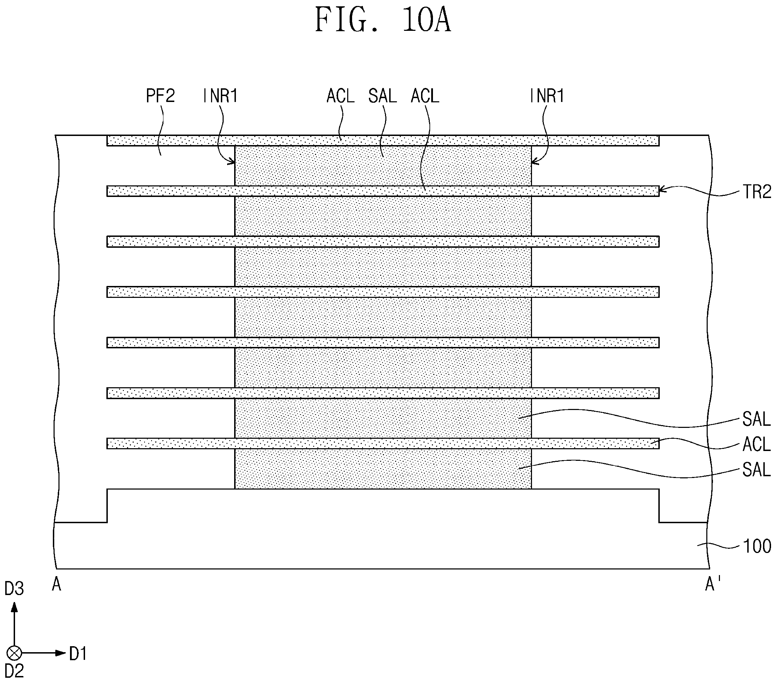

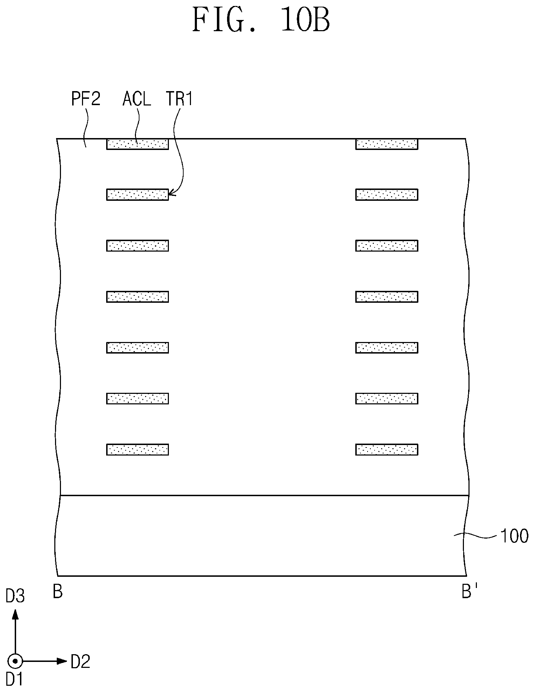

Referring to FIGS. 9 to 10A and 10B, the exposed opposite side surfaces of the sacrificial layers SAL may be selectively removed through the second trenches TR2. Thus, first inner regions INR1 may be formed between the active layers ACL, which are adjacent to each other in the third direction D3. The first preliminary filling patterns PF1 may also be removed during the removal process. Side surfaces of the first preliminary filling patterns PF1 may be aligned to the side surfaces of the sacrificial layers SAL.

A second preliminary filling pattern PF2 may be formed to at least partially fill the first inner regions INR1, an empty region formed by partially removing the first preliminary filling patterns PF1, and the second trenches TR2. The second preliminary filling pattern PF2 may at least partially surround and be on and at least partially cover the active layers ACL, which are not vertically (i.e., D3 direction) overlapped with the sacrificial layers SAL. The second preliminary filling pattern PF2 may include a single or composite layer including an insulating material. In an embodiment, the second preliminary filling pattern PF2 may include silicon oxide and/or silicon nitride.

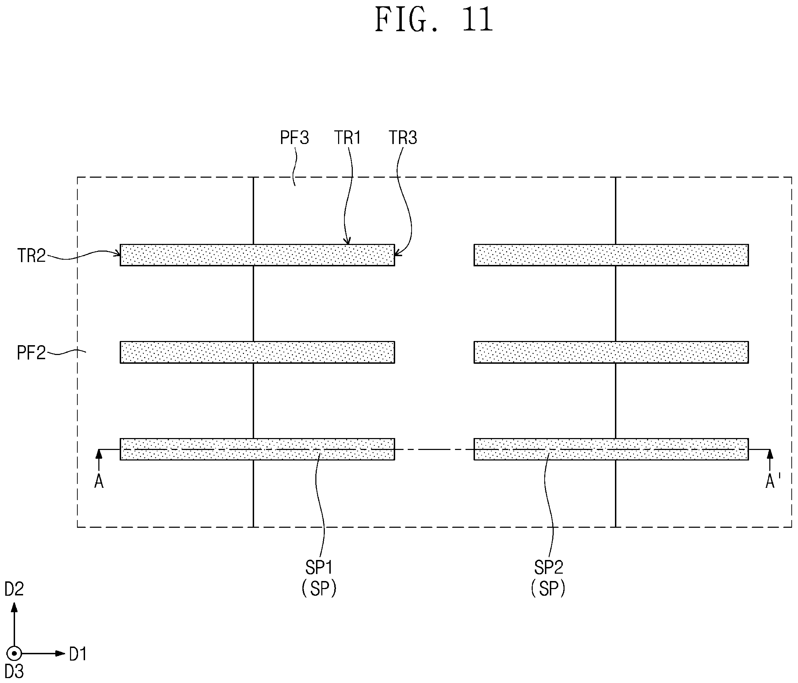

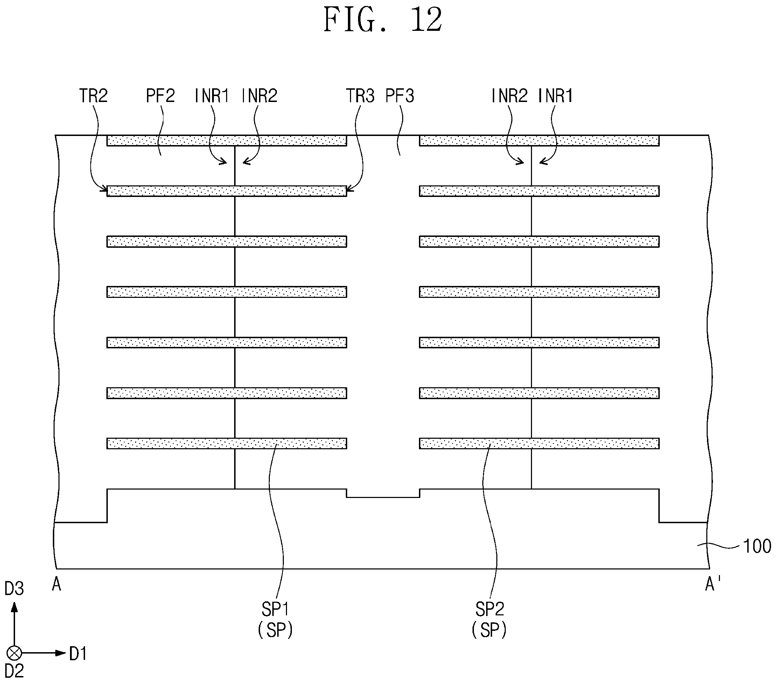

Referring to FIGS. 11 and 12, a third trench TR3 may be formed on the substrate 100 by removing the stem portions of the sacrificial and active layers SAL and ACL extending in the second direction D2. When the third trenches TR3 are formed, each active layer ACL may be divided into the semiconductor patterns SP, which are adjacent to each other in the first direction D1. The semiconductor pattern SP may include the first semiconductor pattern SP1 and the second semiconductor pattern SP2, which are adjacent to each other in the first direction D1. When the third trenches TR3 are formed, the sacrificial layers SAL may be re-exposed to the outside.

All the exposed sacrificial layers SAL may be removed from a region on the substrate 100 through the third trenches TR3. Thus, second inner regions INR2 may be formed between portions of the active layers ACL, which do not overlap with the second preliminary filling pattern PF2 in the D3 direction. During the removal process, all the first preliminary filling patterns PF1 may be removed from a region on the substrate 100. Thereafter, a third preliminary filling pattern PF3 may be formed to at least partially fill the second inner regions INR2, an empty region formed by removing the first preliminary filling patterns PF1, and the third trenches TR3. The third preliminary filling pattern PF3 may include a single or composite layer including an insulating material. In an embodiment, the third preliminary filling pattern PF3 may include silicon oxide and/or silicon nitride.

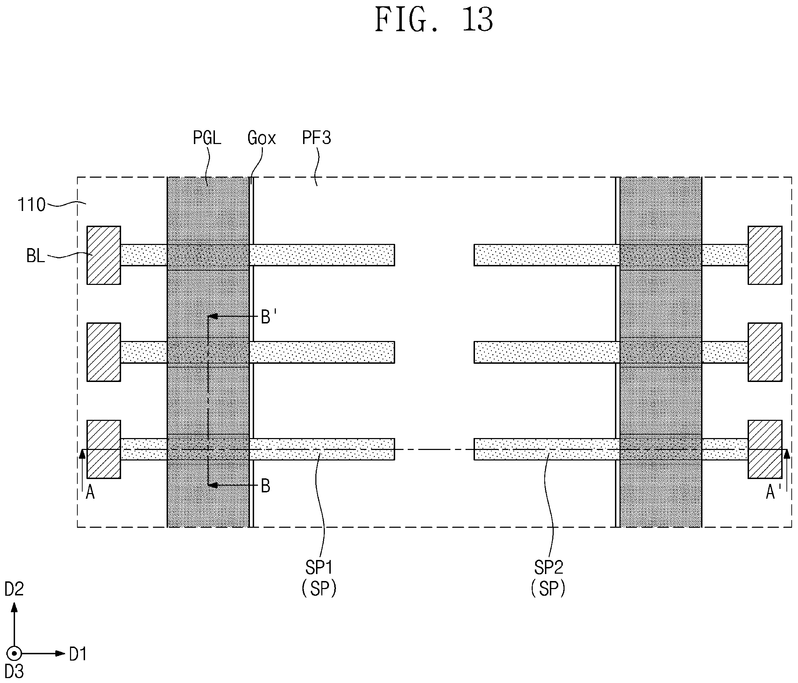

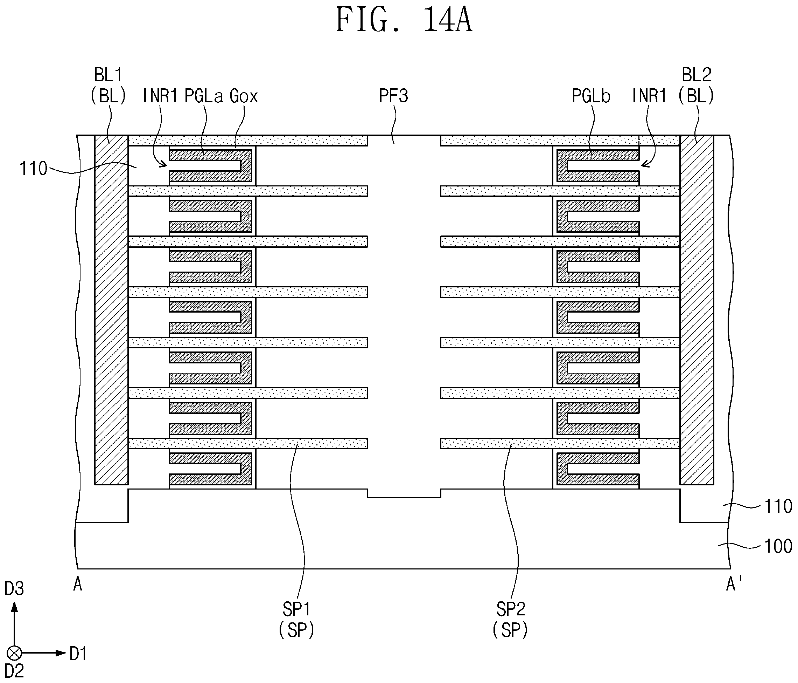

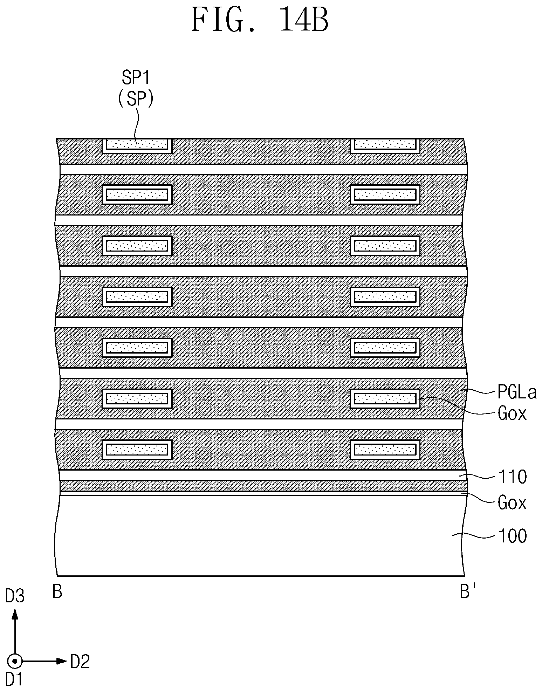

Referring to FIGS. 13 to 14A and 14B, the second preliminary filling pattern PF2 may be removed from a region on the substrate 100. Thereafter, the gate insulating layer Gox and preliminary gate conductive layers PGLa and PGLb (PGL) may be sequentially formed in the first inner regions INR1. The gate insulating layer Gox and the preliminary gate conductive layers PGLa and PGLb may be formed to conformally at least partially cover a portion of the semiconductor pattern SP. Each gate insulating layer Gox and one of the preliminary gate conductive layers PGLa and PGLb may be formed to at least partially surround and at least partially cover a portion of each of the semiconductor patterns SP, which are adjacent to each other in the second and third directions D2 and D3. Thereafter, the gapfill insulating pattern 110 may be formed in a region, which is formed by removing the first inner regions INR1 and the second preliminary filling pattern PF2.

The bit lines BL may be formed to penetrate or extend through the gapfill insulating pattern 110 and to be in contact with side surfaces of the semiconductor patterns SP. The bit lines BL may include the first bit lines BL1, which are in contact with the first semiconductor patterns SP1, and the second bit lines BL2, which are in contact with the second semiconductor patterns SP2.

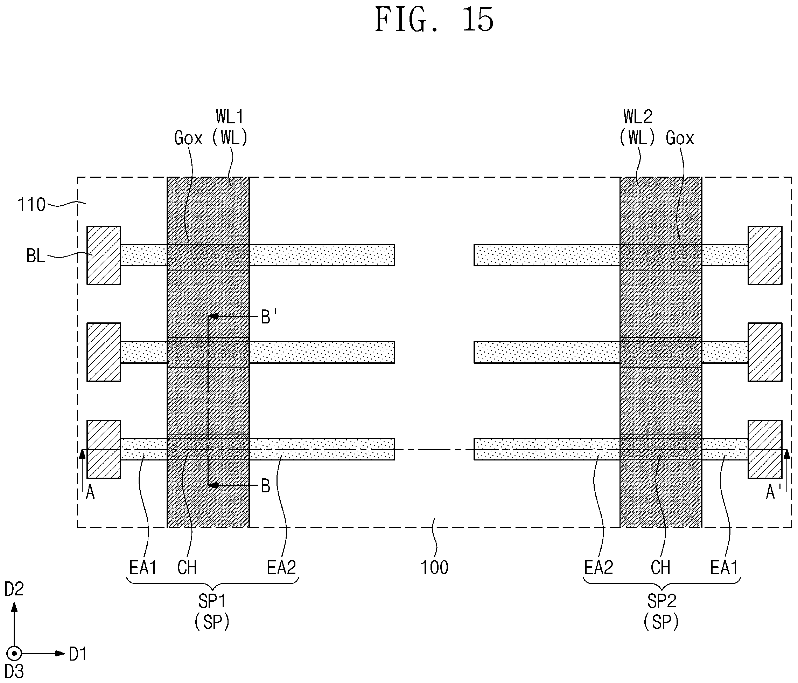

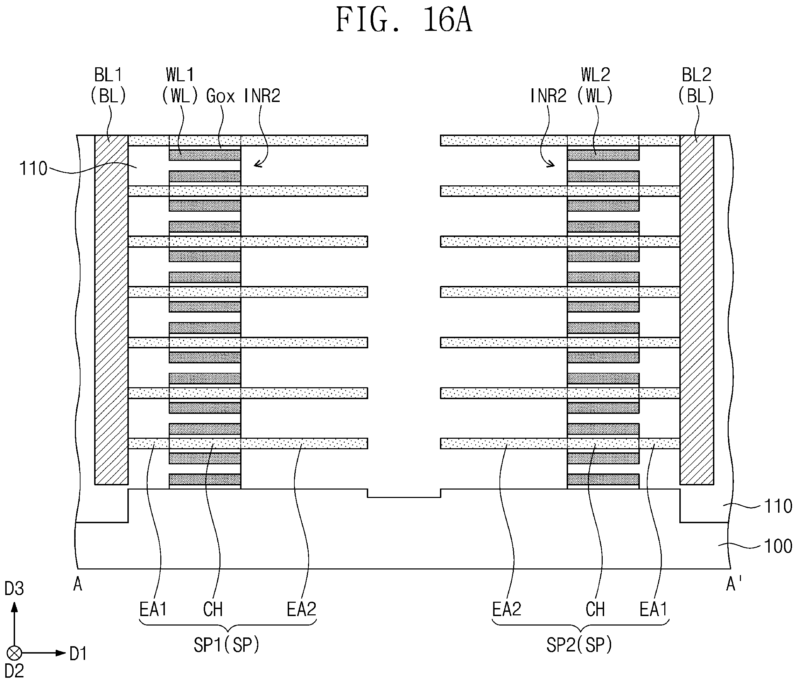

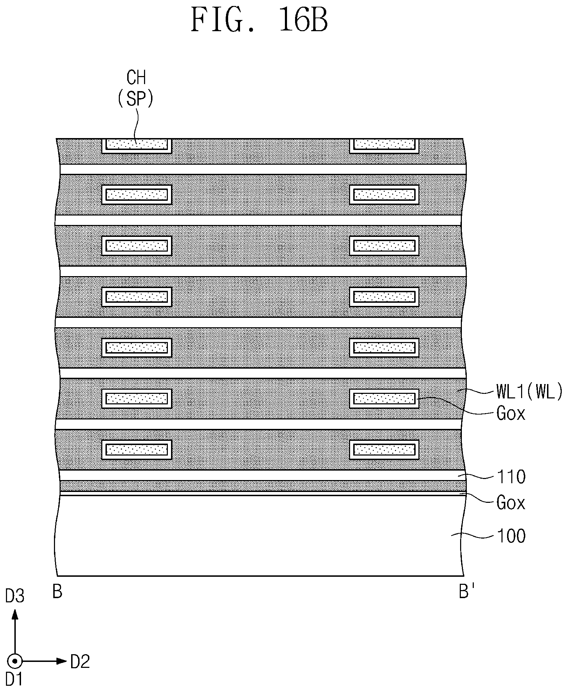

Referring to FIGS. 15 to 16A and 16B, the third preliminary filling pattern PF3 may be removed from a region on the substrate 100. A portion of the gate insulating layer Gox and portions of the preliminary gate conductive layers PGLa and PGLb may also be removed during the removal process. Accordingly, each gate insulating layer Gox may be divided into a plurality of the gate insulating layers Gox, which are spaced apart from each other in the second and third directions D2 and D3. In addition, each of the preliminary gate conductive layers PGLa and PGLb may be divided into a plurality of word lines WL1 and WL2, which are spaced apart from each other in the second and third directions D2 and D3. Each of the gate insulating layers Gox may at least partially enclose a corresponding one of the semiconductor patterns SP. Each of the word lines WL may at least partially enclose a corresponding one of the semiconductor patterns SP and the gate insulating layer Gox.

During the removal process, the second inner regions INR2 may be at least partially exposed to the outside. Side surfaces of the word lines WL may be at least partially exposed to the outside through the second inner regions INR2.

The word lines WL may include the first word lines WL1 at least partially enclosing the first semiconductor patterns SP1 and the second word lines WL2 at least partially enclosing the second semiconductor patterns SP2.

A portion of the first semiconductor pattern SP1 at least partially enclosed by the first word line WL1 may be referred to as the channel region CH of the first semiconductor pattern SP1. A portion of the second semiconductor pattern SP2 enclosed by the second word line WL2 may be referred to as the channel region CH of the second semiconductor pattern SP2.

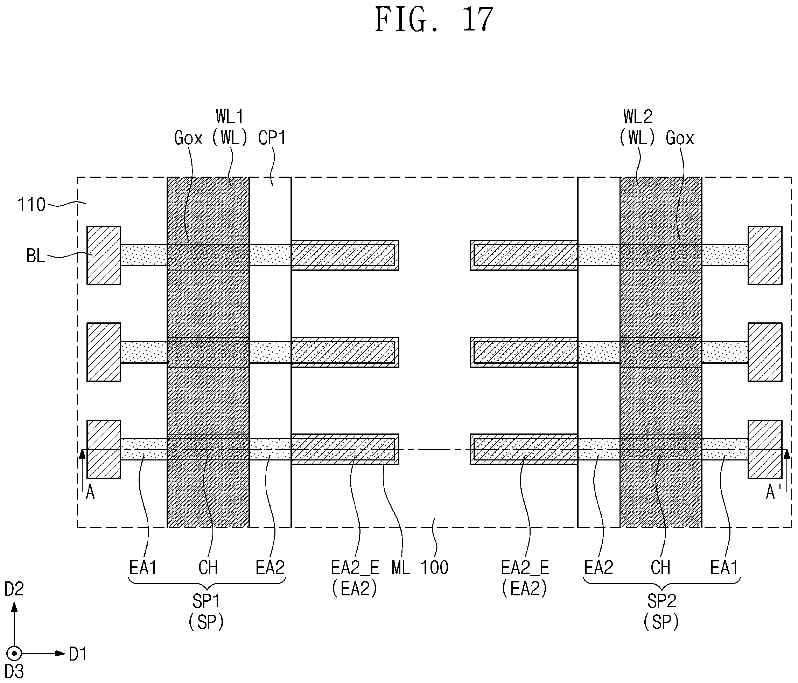

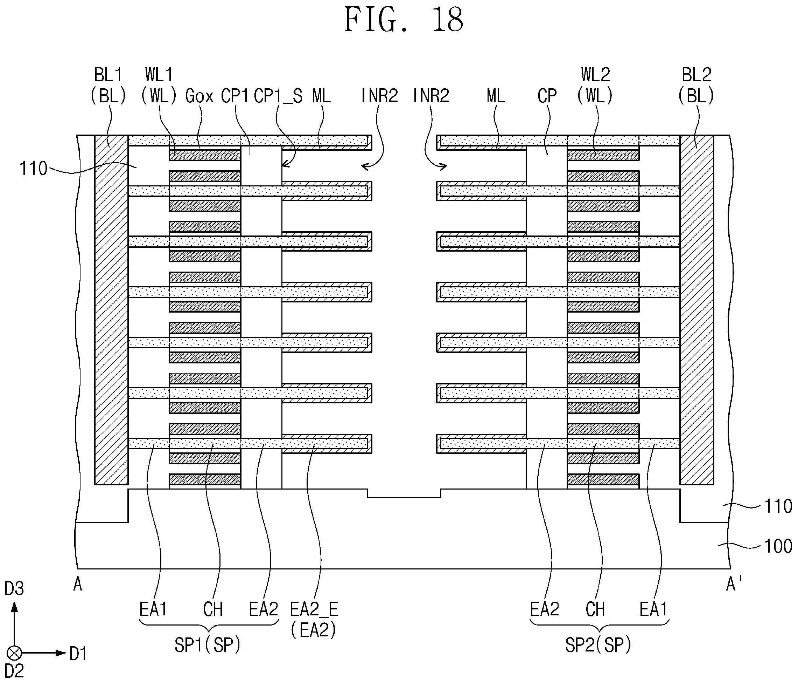

Referring to FIGS. 17 and 18, the first capping pattern CP1 (CP) may be formed to at least partially fill a portion of the second inner region INR2. The first capping pattern CP1 may be provided to partially surround the second edge portions EA2 of the semiconductor patterns SP. Thus, a portion EA2_E of the second edge portions EA2 may be exposed to the outside.

Thereafter, a metal layer ML may be deposited on the exposed portion EA2_E of the second edge portion EA2 of the semiconductor pattern SP. The metal layer ML may be formed to at least partially cover a side surface of the first capping pattern CP1 and the exposed portion EA2_E. The metal layer ML may be more easily deposited on the portion EA2_E of the second edge portion EA2 than on the first capping pattern CP1. The metal layer ML may contain the first metal element. Next, a portion of the metal layer ML may be removed to expose a side surface CP1_S of the first capping pattern CP 1. In an embodiment, the removal process may be performed using a wet etching process. As a result of the removal process, the metal layer ML may be divided into a plurality of patterns, which are spaced apart from each other in the second and third directions D2 and D3, and each of which is formed to at least partially cover the portion EA2_E of the second edge portion EA2.

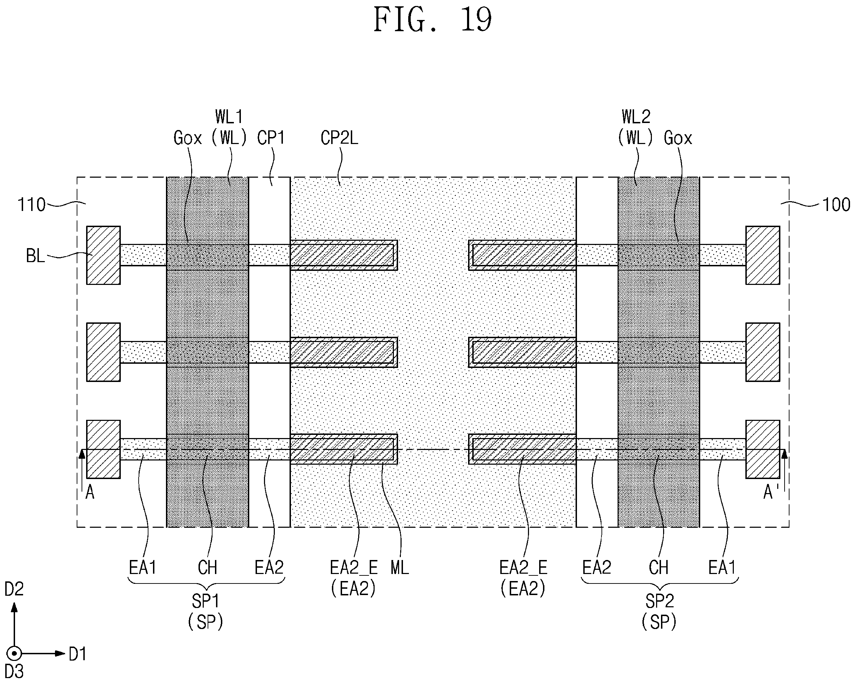

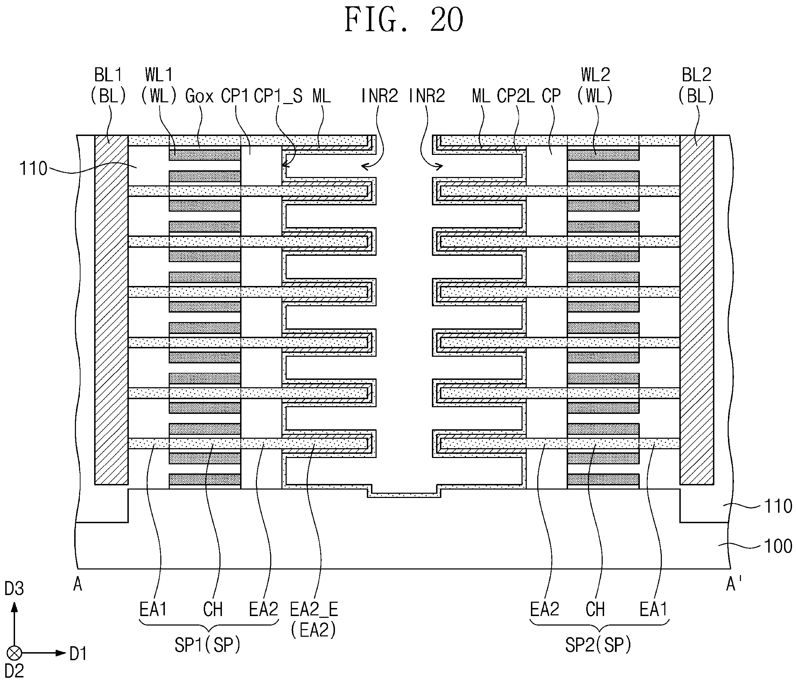

Referring to FIGS. 19 and 20, a second capping layer CP2L may be formed to at least partially cover the exposed second inner region INR2. The second capping layer CP2L may conformally at least partially cover the side surface CP1_S of the first capping pattern CP1 and the metal layers ML. In addition, the second capping layer CP2L may cover a portion of the top surface of the substrate 100. The second capping layer CP2L may be an oxygen-containing insulating layer. In an embodiment, the second capping layer CP2L may include a metal oxide material containing the second metal element, but embodiments of the inventive concept are not limited to this example.

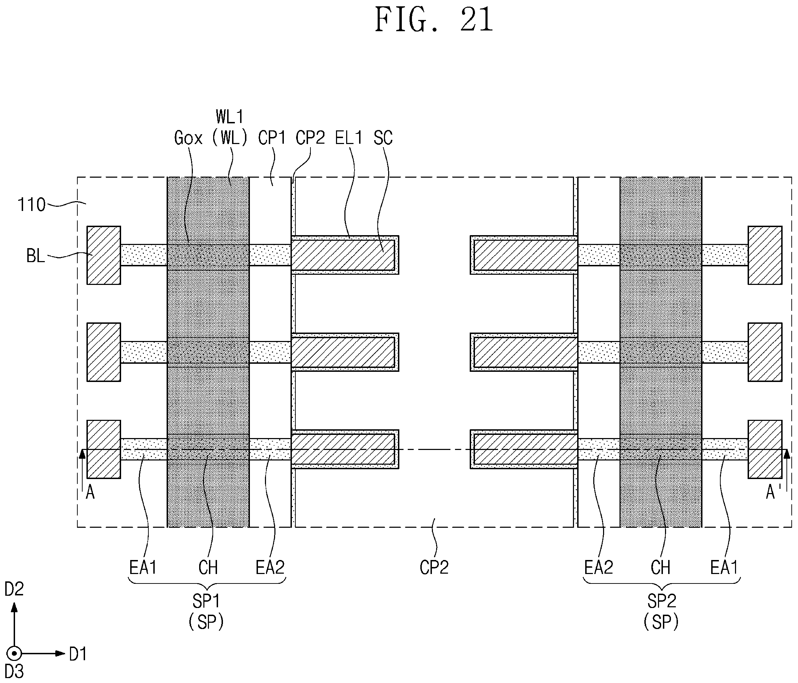

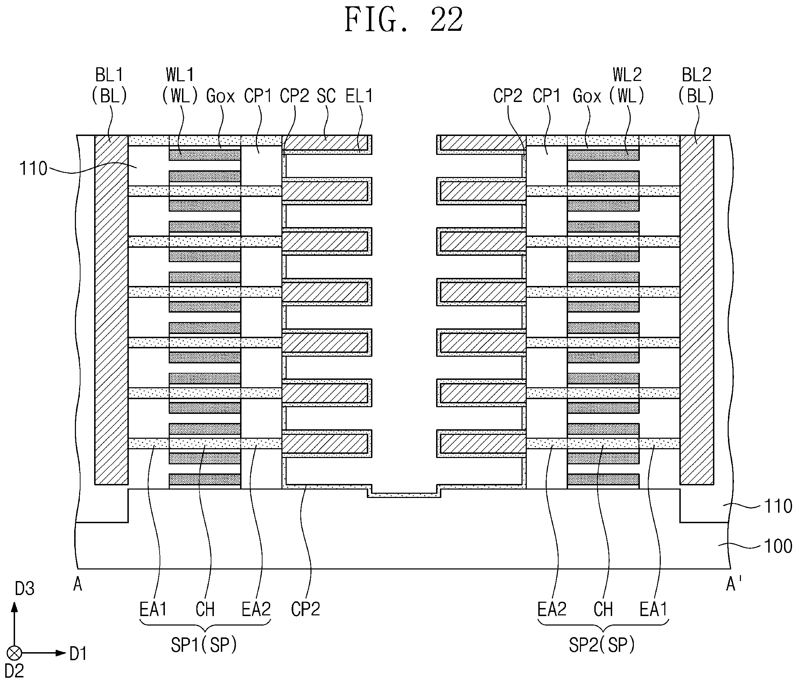

Referring to FIGS. 21 and 22, a thermal treatment process may be performed to form the metal silicide pattern SC and the first electrode EL1. For example, as a result of the thermal treatment process being performed, the first metal element of the metal layer ML may be diffused into portions (e.g., an end portion EA2_E of the second edge portions EA2 of the semiconductor pattern SP and a portion of the second capping layer CP2L), which are in contact with the metal layer ML (e.g., see FIG. 20). In other words, the metal silicide patterns SC may be formed as a result of the diffusion of the first metal element into the end portions EA2_E of the second edge portions EA2 of the semiconductor pattern SP (e.g., see FIG. 20). The first electrodes EL1 may be formed as a result of the diffusion of the first metal element into the portion of the second capping layer CP2L. The second capping layer CP2L may be divided into the first electrodes EL1, which are doped with the first metal element, and the second capping pattern CP2, which is not doped with the first metal element. The first electrodes EL1 may be formed to at least partially enclose the metal silicide pattern SC and may be spaced apart from each other in the second and third directions D2 and D3. The second capping pattern CP2 may be spaced apart from the metal silicide pattern SC and may be in contact with the side surface of the first capping pattern CP1.

According to an embodiment of the inventive concept, the metal layer ML (e.g., of FIG. 20) and the second capping layer CP2L (e.g., of FIG. 20) may be sequentially formed on an exposed side surface of the semiconductor pattern SP, and the metal silicide patterns SC and the first electrodes EL1 may be formed at the same time through a thermal treatment process. In this case, the fabrication process of the three-dimensional semiconductor device may be simplified.

Referring back to FIGS. 3 to 4A and 4B, the dielectric layer CIL and the second electrode EL2 may be sequentially formed to conformally at least partially cover the first electrodes EL1. Thereafter, the plate electrode PE may be deposited on the second electrode EL2 to at least partially fill a space between the metal silicide patterns SC. Next, the protection layer PL may be formed to at least partially cover the cell array structure CS.

According to an embodiment of the inventive concept, because the first electrodes EL1 have an oxidation-resistant property, them may not deteriorate by an ozone (O3) reaction in a process of forming the dielectric layer CIL. Thus, an additional oxidation-preventing layer may not be required between the first electrodes EL1 and the dielectric layer CIL. That is, the oxidation-preventing layer enclosing the first electrodes EL1 may be omitted, and thus, a pitch between adjacent ones of the first electrodes EL1 may be reduced. Thus, it may be possible to increase the number of the first electrodes EL1 disposed in the capacitor CAP. Thus, an integration density of the three-dimensional semiconductor device may be increased.

According to an embodiment of the inventive concept, a first electrode may be formed to at least partially surround a metal silicide pattern and may include a metal oxide material. The first electrode may have an oxidation-resistant property, and thus, an additional oxidation-preventing layer may not be formed in a subsequent process of forming a dielectric layer on the first electrode. In this case, it may be possible to omit an oxidation-preventing layer enclosing the first electrode and to reduce a pitch between adjacent ones of the first electrodes. Accordingly, the number of the first electrodes in a capacitor may be increased. This may make it possible to increase an integration density of a three-dimensional semiconductor device. Furthermore, the first electrode may be formed during a process of forming the metal silicide pattern, and in this case, the fabrication process may be simplified.

Embodiments are set out in the following clauses:
Clause 1. A three-dimensional semiconductor device, comprising: a semiconductor pattern extending in a first direction parallel to a bottom surface of a substrate; a word line surrounding a portion of the semiconductor pattern and extending in a second direction, which is parallel to the bottom surface of the substrate and is orthogonal to the first direction; a bit line on a first side surface of the semiconductor pattern and extending in a third direction perpendicular to the bottom surface of the substrate; a capacitor on a second side surface of the semiconductor pattern opposite to the first side surface; and a metal silicide pattern between the capacitor and the second side surface of the semiconductor pattern, wherein the capacitor comprises a first electrode enclosing the metal silicide pattern, a second electrode on the first electrode, and a dielectric layer between the first electrode and the second electrode, and wherein the first electrode comprises a metal oxide material.
Clause 2. The three-dimensional semiconductor device of clause 1, wherein both the first electrode and the metal silicide pattern comprise a first metal element.
Clause 3. The three-dimensional semiconductor device of clause 2, wherein the first metal element comprises one of titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), or zirconium (Zr).
Clause 4. The three-dimensional semiconductor device of clause 3, wherein the first electrode further comprises a second metal element different from the first metal element, and wherein the second metal element comprises one of titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), or zirconium (Zr).
Clause 5. The three-dimensional semiconductor device of clause 4, wherein a work function of the second metal element ranges from 4.5 eV to 50 eV.
Clause 6. The three-dimensional semiconductor device of any preceding clause, wherein the semiconductor pattern comprises a first edge portion, a channel region, and a second edge portion, which are sequentially arranged in the first direction, wherein the three-dimensional semiconductor device further comprises: a first capping pattern interposed between the word line and the capacitor to enclose the second edge portion; and a second capping pattern on a side surface of the first capping pattern.
Clause 7. The three-dimensional semiconductor device of clause 6, wherein the metal silicide pattern is in contact with a side surface of the first capping pattern and a side surface of the second edge portion.
Clause 8. The three-dimensional semiconductor device of clause 6 or 7, wherein the first electrode is in contact with the first capping pattern and the second capping pattern.
Clause 9. The three-dimensional semiconductor device of any preceding clause, wherein a thickness of the metal silicide pattern in the third direction is greater than a thickness of the semiconductor pattern in the third direction.
Clause 10. The three-dimensional semiconductor device of any preceding clause, wherein the second electrode comprises a metal nitride, and wherein the first electrode does not contain nitrogen (N).
Clause 11. The three-dimensional semiconductor device of any preceding clause, wherein a thickness of the first electrode ranges from 0 Å to 50 Å.
Clause 12. The three-dimensional semiconductor device of any preceding clause, further comprising a plate electrode on the second electrode.
Clause 13. A three-dimensional semiconductor device, comprising: a semiconductor pattern extending in a first direction parallel to a bottom surface of a substrate; a word line surrounding a portion of the semiconductor pattern and extending in a second direction, which is parallel to the bottom surface of the substrate and is orthogonal to the first direction; a bit line on a first side surface of the semiconductor pattern and extending in a third direction perpendicular to the bottom surface of the substrate; a metal silicide pattern on a second side surface of the semiconductor pattern opposite to the first side surface; and a first electrode enclosing the metal silicide pattern, wherein the metal silicide pattern comprises a first metal element and silicon, and wherein the first electrode comprises the first metal element and oxygen.
Clause 14. The three-dimensional semiconductor device of clause 13, wherein the first metal element comprises one of titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), or zirconium (Zr).
Clause 15. The three-dimensional semiconductor device of clause 14, wherein the first electrode further comprises a second metal element different from the first metal element, and wherein the second metal element comprises one of titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), or zirconium (Zr).
Clause 16. The three-dimensional semiconductor device of clause 13, 14 or 15, wherein the semiconductor pattern comprises a first edge portion, a channel region, and a second edge portion, which are sequentially arranged in the first direction, wherein the bit line is in contact with the first edge portion, and wherein the metal silicide pattern is in contact with the second edge portion.
Clause 17. The three-dimensional semiconductor device of clause 16, wherein the first electrode is spaced apart from the second edge portion.
Clause 18. The three-dimensional semiconductor device of clause 16 or 17, wherein a thickness of the metal silicide pattern in the third direction is greater than a thickness of the second edge portion in the third direction.
Clause 19. A three-dimensional semiconductor device, comprising: a first stack and a second stack, which are on a substrate and are adjacent to each other in a first direction parallel to a bottom surface of the substrate; and a data storage pattern between the first stack and the second stack, wherein the first stack comprises: a first semiconductor pattern spaced apart from the substrate and extending in the first direction; a first word line surrounding a portion of the first semiconductor pattern and extending in a second direction, which is parallel to the bottom surface of the substrate and is orthogonal to the first direction; a first bit line provided on a first side surface of the first semiconductor pattern and extending in a third direction perpendicular to the bottom surface of the substrate; and a metal silicide pattern on a second side surface of the first semiconductor pattern, wherein the data storage pattern comprises: a first electrode enclosing the metal silicide pattern; a second electrode on the first electrode; a dielectric layer between the first electrode and the second electrode; and a plate electrode in contact with the second electrode, wherein the first electrode comprises a metal oxide material.
Clause 20. The three-dimensional semiconductor device of clause 19, wherein the second stack comprises: a second semiconductor pattern spaced apart from the substrate and extending in the first direction; a second word line enclosing a portion of the second semiconductor pattern and extending in the second direction; and a second bit line on a side surface of the second semiconductor pattern and extending in the third direction.

While example embodiments of the inventive concept have been particularly shown and described, it will be understood by one of ordinary skill in the art that variations in form and detail may be made therein without departing from the scope of the attached claims.

## Claims

1. A three-dimensional semiconductor device, comprising:
a semiconductor pattern extending in a first direction parallel to a bottom surface of a substrate;
a word line surrounding a portion of the semiconductor pattern and extending in a second direction, which is parallel to the bottom surface of the substrate and is orthogonal to the first direction;
a bit line on a first side surface of the semiconductor pattern and extending in a third direction perpendicular to the bottom surface of the substrate;
a capacitor on a second side surface of the semiconductor pattern opposite to the first side surface; and
a metal silicide pattern between the capacitor and the second side surface of the semiconductor pattern,
wherein the capacitor comprises a first electrode enclosing the metal silicide pattern, a second electrode on the first electrode, and a dielectric layer between the first electrode and the second electrode, and
wherein the first electrode comprises a metal oxide material.

2. The three-dimensional semiconductor device of claim 1, wherein both the first electrode and the metal silicide pattern comprise a first metal element.

3. The three-dimensional semiconductor device of claim 2, wherein the first metal element comprises one of titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), or zirconium (Zr).

4. The three-dimensional semiconductor device of claim 2 or 3, wherein the first electrode further comprises a second metal element different from the first metal element, and
wherein the second metal element comprises one of titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), or zirconium (Zr).

5. The three-dimensional semiconductor device of claim 4, wherein a work function of the second metal element ranges from 4.5 eV to 50 eV.

6. The three-dimensional semiconductor device of any preceding claim, wherein the semiconductor pattern comprises a first edge portion, a channel region, and a second edge portion, which are sequentially arranged in the first direction,
wherein the three-dimensional semiconductor device further comprises:
a first capping pattern interposed between the word line and the capacitor to enclose the second edge portion; and
a second capping pattern on a side surface of the first capping pattern.

7. The three-dimensional semiconductor device of claim 6, wherein the metal silicide pattern is in contact with a side surface of the first capping pattern and a side surface of the second edge portion.

8. The three-dimensional semiconductor device of claim 6 or 7, wherein the first electrode is in contact with the first capping pattern and the second capping pattern.

9. The three-dimensional semiconductor device of any preceding claim, wherein a thickness of the metal silicide pattern in the third direction is greater than a thickness of the semiconductor pattern in the third direction.

10. The three-dimensional semiconductor device of any preceding claim, wherein the second electrode comprises a metal nitride, and
wherein the first electrode does not contain nitrogen (N).

11. The three-dimensional semiconductor device of any preceding claim, wherein a thickness of the first electrode ranges from 0 Å to 50 Å.

12. The three-dimensional semiconductor device of any preceding claim, further comprising a plate electrode on the second electrode.

13. The three-dimensional semiconductor device of claim 1,
wherein the metal silicide pattern comprises a first metal element and silicon, and
wherein the first electrode comprises the first metal element and oxygen.

14. The three-dimensional semiconductor device of claim 13, wherein the first metal element comprises one of titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), or zirconium (Zr).

15. The three-dimensional semiconductor device of claim 14, wherein the first electrode further comprises a second metal element different from the first metal element, and
wherein the second metal element comprises one of titanium (Ti), cobalt (Co), nickel (Ni), copper (Cu), tungsten (W), niobium (Nb), tantalum (Ta), manganese (Mn), indium (In), molybdenum (Mo), vanadium (V), hafnium (Hf), or zirconium (Zr).
